(19) Europäisches Patentamt
European Patent Office
Office européen des brevets

(11) EP 2 175 516 A1

(12) EUROPEAN PATENT APPLICATION
published in accordance with Art. 153(4) EPC

(43) Date of publication:
14.04.2010 Bulletin 2010/15

(51) Int Cl.:
H01M 14/00 (2006.01)   H01L 31/04 (2006.01)

(21) Application number: 08752598.6

(22) Date of filing: 12.05.2008

(86) International application number:
PCT/JP2008/058718

(87) International publication number:
WO 2009/016869 (05.02.2009 Gazette 2009/06)

(84) Designated Contracting States:
AT BE BG CH CY CZ DE DK EE ES FI FR GB GR
HR HU IE IS IT LI LT LU LV MC MT NL NO PL PT
RO SE SI SK TR
Designated Extension States:
AL BA MK RS

(30) Priority: 27.07.2007 JP 2007195725

(71) Applicant: Sony Corporation
Tokyo 108-0075 (JP)

(72) Inventors:
• YONEYA, Reiko
Tokyo 108-0075 (JP)
• MOROOKA, Masahiro
Tokyo 108-0075 (JP)
• SUZUKI, Yusuke
Tokyo 108-0075 (JP)

(74) Representative: Thévenet, Jean-Bruno et al
Cabinet Beau de Loménie
158, rue de l'Université
75340 Paris Cédex 07 (FR)

(54) COLORING MATTER-SENSITIZED PHOTOELECTRIC CONVERSION ELEMENT, PROCESS FOR PRODUCING THE COLORING MATTER-SENSITIZED PHOTOELECTRIC CONVERSION ELEMENT, ELECTRONIC EQUIPMENT, SEMICONDUCTOR ELECTRODE, AND PROCESS FOR RPODUCING THE SEMICONDUCTOR ELECTRODE

(57) In a dye sensitized photoelectric conversion device having an electrolyte layer (6) between a semiconductor electrode (3) including, for example, fine semiconductor particles to which a sensitizing dye is adsorbed and a counter electrode (5), two kinds of dyes are used as the dye, and the two kinds of dyes are adsorbed onto the surface of the semiconductor electrode (3) at the sites different from each other. The fine semiconductor particles include, for example, $TiO_2$. Tris(isothiocyanate)-ruthenium(II)-2,2':6',2"-terpyridine-4,4',4"-tricarboxylic acid and 2-cyano-3-[4-[4-(2,2-diphenylethenyl)phenyl]-1,2,3,3a,4,8b-hexahydrocyclopent[b]indol-7-yl]-2-propenoic acid are used, for example, as the two kinds of dyes. Thereby, a dye sensitized photoelectric conversion device such as a dye sensitized solar cell capable of obtaining higher light absorption rate and photoelectric conversion efficiency than in a case of using one kind of dye at high purity, as well as a manufacturing method thereof are provided.

FIG. 1

**Description**

Technical Field

The present invention relates to a dye sensitized photoelectric conversion device and a manufacturing method thereof, an electronic equipment, and a semiconductor electrode and a manufacturing method thereof, which are suitable to application, for example, in a dye sensitized solar cell using a semiconductor electrode including fine semiconductor particles to which a sensitizing dye is adsorbed.

Background Art

Since a solar cell as a photoelectric conversion device for converting solar light into electric energy uses the solar light as an energy source, it gives extremely less effect on global environments and a further popularization has been expected.

While various materials have been studied for solar cells, a number of those using silicon have been marketed and they are generally classified into crystalline silicon type solar cells using single crystal or polycrystal silicon, and noncrystalline (amorphous) silicon type solar cells. Heretofore, single crystal or polycrystal silicon, that is, crystalline silicon has been used frequently for the solar cells.

However, in the crystalline silicon solar cells, while the phtoelectronic conversion efficiency representing the performance of converting light (solar) energy into electric energy is higher compared with that of the amorphous silicon solar cells, since they require much energy and time for crystal growth, the productivity is low and they are disadvantageous in view of the cost.

Further, while the amorphous silicon solar cells have a feature that light absorption rate is higher, substrate selection range is wide, and increase of area is easy when compared with the crystalline silicon solar cells, the photoelectric conversion efficiency is lower than that of the crystalline silicon solar cells. Further, while the amorphous silicon solar cells have higher productivity compared with that of the crystallize silicon solar cells, they also require a vacuum process for the production in the same manner as in the crystalline silicon solar cells and the burden in term of installation is still large.

On the other hand, it has been studied long since on solar cells using organic materials instead of silicon type materials for solving the problems described above and further reducing the cost of the solar cells. However, the photoelectric conversion efficiency of most of the solar cells is as low as about 1%, and they have not yet been put to practical use.

Among them, dye sensitized solar cells (photoelectrochemical cells) proposed by the group of Grätzel, et al. have attracted attention since they are inexpensive, show high photoelectric conversion efficiency, and do not require a large-scale apparatus upon manufacture different from existent silicon solar cells, etc. (refer, for example, to B. O'Regan, M. Graetzel, Nature, 353, pp. 737-749 (1991) and Specification of Patent No. 2664194).

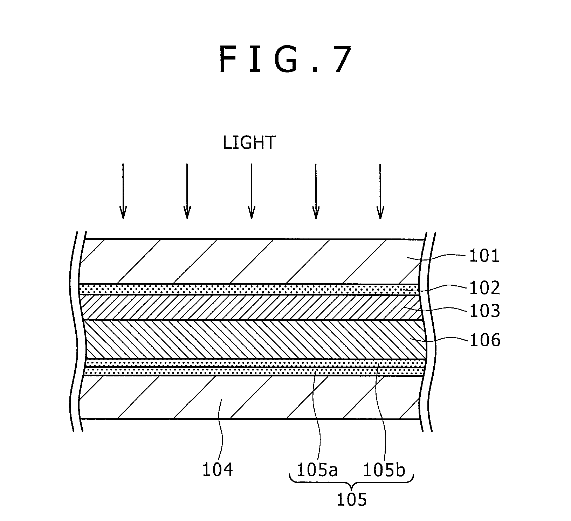

Fig. 7 shows a structure of a general existent dye sensitized solar cell and, more generally, a dye sensitized photoelectric conversion device. As shown in Fig. 7, the dye sensitized photoelectric conversion device generally has a structure in which a portion having a transparent electrode 102 including, for example, FTO (fluoro doped tin oxide) formed on a transparent substrate 101 made of glass or the like, on which a semiconductor layer 103 is formed with adsorption of a sensitizing dye, and a counter electrode 105 including an electrode 105a, for example, made of FTO and a conduction layer 105b such as a platinum layer which are formed on a substrate 104 are opposed to each other, and an electrolyte layer 106 including an organic liquid electrolyte containing oxidation/reduction species (redox pair) such as $I^-/I_3^-$ is filled between them. An external circuit is connected between the transparent electrode 102 and the counter electrode 105. As the semiconductor layer 103, a porous layer formed by sintering fine semiconductor particles such as of titanium oxide ($TiO_2$) is often used. A sensitizing dye is adsorbed onto the surface of fine semiconductor particles that constitute the semiconductor layer 103.

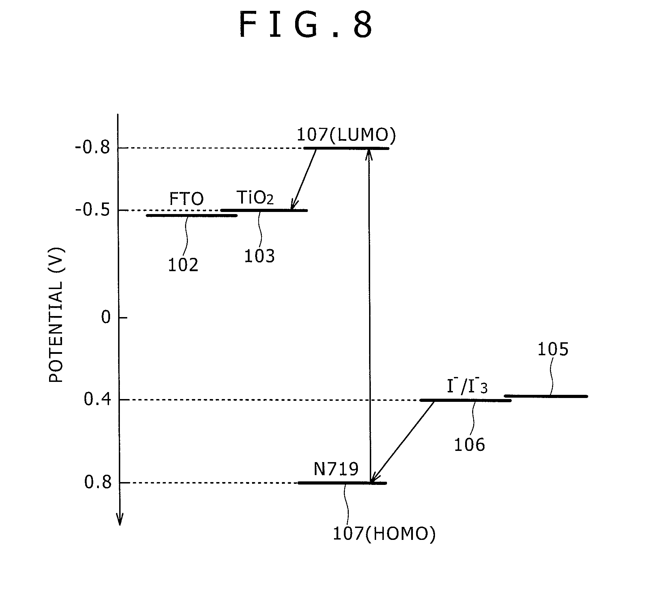

The operation principle of the dye sensitized photoelectric conversion device will be described with reference to an energy diagram shown in Fig. 8. However, in Fig. 8, it is considered a case of using FTO as a material for the transparent electrode 102, N719 to be described later as a sensitizing dye 107, $TiO_2$ as the material for the semiconductor layer 103, and $I^-/I_3^-$ as oxidation/reduction species. When light is incident from the side of the transparent substrate 101, the dye sensitized photoelectric conversion device operates as a cell using the counter electrode 105 as a positive electrode and the transparent electrode 102 as the negative electrode. The principle is as described below.

That is, when the dye 107 absorbs photons transmitted through the transparent substrate 101 and the transparent electrode 102, electrons in the dye 107 are excited from a ground state (HOMO) to an excited state (LUMO). The thus excited electrons are drawn to the conduction band of the semiconductor layer 103 and reach the transparent electrode 102 passing through the semiconductor layer 103.

On the other hand, the dye 107 deprived of the electrons receives electrons from a reducing agent, that is, $I^-$ in the electrolyte layer 106 according to the following reaction:

$$2I^- \rightarrow I_2 + 2e^-$$

$$I_2 + I^- \rightarrow I_3^-$$

thereby forming an oxidant, that is, $I_3^-$ (bonded body of $I_2$ and $I^-$) in the electrolyte layer 106. The thus formed oxidant reaches the counter electrode 105 by way of diffusion and receives electrons from the counter electrode 105 by the reaction reverse to the reaction described above:

$$I_3^- \rightarrow I_2 + I^-$$

$$I_2 + 2e^- \rightarrow 2I^-$$

and is reduced to the reducing agent in the initial state.

The electrons sent from the transparent electrode 102 to the external circuit conduct an electric work in the external circuit and then return to the counter electrode 105. In this way, light energy is converted into electric energy leaving no change in the dye 107 and in the electrolyte layer 106.

As the dye 107 adsorbed to the semiconductor layer 103, a material capable of absorbing a light near a visible light region, for example, a bipyridine complex, terpyridine complex, merocyanine dye, porphyrin, phthalocyanine or the like is used usually.

Heretofore, it is considered that a single kind of dye of high purity is used preferably as the sensitizing dye for attaining a high photoelectric conversion efficiency in the dye sensitized photoelectric conversion device. This is because it has been considered that when a plurality kinds of dyes are present together on the semiconductor layer 103, donation and reception of electron or electron-hole recombination occurs between the dyes to each other, or electrons transferred from the excited dye to the semiconductor layer 103 are captured by the other kind of the dye to decrease electrons reaching the transparent electrode 102 from the excited dye 107 and the efficiency of obtaining the current from the absorbed photons, that is, the quantum yield is remarkably lowered (for example, refer to: K. Hara, K. Miyamoto, Y. Abe, M. Yanagida, Journal of Physical Chemistry B, 109(50), p.23776-23778 (2005); Masatoshi Yanagida, et al., 2005, Photochemical Discussion Meeting, 2P132, "Electron transport process in dye sensitized titanium oxide nanocrystal electrode to which a ruthenium dipyridine complex and a ruthenium biquinoline complex are co-adsorbed"; and "Retrieved, July 24, 2007" internet (URL: http:/kuroppe.tagen.tohoku.ac,JP/⁻dsc/cell.html, "On Theoretical Efficiency of Dye Sensitized Solar Cell" in FAQ).

As the sensitizing dye used solely, cis-bis(isothiacyanate)bis(2,2'-bipyridyl-4,4'-dicarboxylic acid) ruthenium(II) ditetraburyl ammonium complex (hereinafter referred to as "N719") as a kind of bipyridine complexes is excellent in the performance as the sensitizing dye and has been used generally. In addition, cis-bis(isocyanate)bis(2,2'-bipyridyl-4,4'-dicarboxylic acid)ruthenium(II) (hereinafter referred to as "N3") as a kind of bipyridine complexes, or tris(isocyanate) (2,2':6',2''-terpyridyl-4,4',4''-tricarboxylic acid)ruthenium(II)tritetrabutyl ammonium complex (hereinafter referred to as "black dye") as a kind of terpyridine complexes is used generally.

Particularly, in a case of using the N3 or the black dye, co-adsorbent is also used frequently. The co-adsorbent is a molecule which is added for preventing association of dye molecules on the semiconductor layer 103 and the typical co-adsorbent includes, for example, chenodeoxycholic acid, taurodeoxycholic acid salt, and 1-decryl phosphonic acid. As the structural features of these molecules, it is mentioned that they have a carboxyl group or phosphono group as a functional group easily adsorbed to titanium oxide that constitutes the semiconductor layer 103, and that they are formed with a σ bond for preventing interference between dye molecules by intervention between the dye molecules.

Generally, for effectively operating the photoelectric conversion device, it is important at first to enhance the light absorption rate such that the light incident to the photoelectric conversion device can be utilized to the maximum. Next, it is important to enhance the conversion efficiency of converting the absorbed light energy into electric energy (photoelectric conversion efficiency). In the dye sensitized photoelectric conversion device, since the dye 107 has a role for light absorption, it is expected that the highest light absorption rate can be attained by selecting a dye having a light absorption characteristics optimal to the incident light as the dye 107.

Since the solar light contains lights of various wavelengths continuously from infrared light to ultra-violet light, for attaining high light absorption rate in a case of applying the dye sensitized photoelectric conversion device to the solar cell, it is desirable for the dye 107 to select a dye capable of absorbing a light in a wavelength region for a range as wide as possible including also a long wavelength region, particularly, a light at a wavelength of 300 to 900 nm thoroughly.

However, the state of electrons in the dye 107 is determined in term of quantum mechanics and they can take only the energy state inherent to a substance. Accordingly, the energy difference between the electron at the ground state (HOMO) and the electron at the excited state (LUMO), that is, an energy necessary for exciting an electron from the ground state to the excited state (band gap energy) is also determined as a value inherent to the substance and, correspondingly, the light that can be absorbed to the dye 107 is restricted to a light in a specified wavelength region.

Further, it is necessary that the band gap energy of the dye 107 is not excessively small such that the excited electrons can transfer to the conduction band of the semiconductor layer 103.

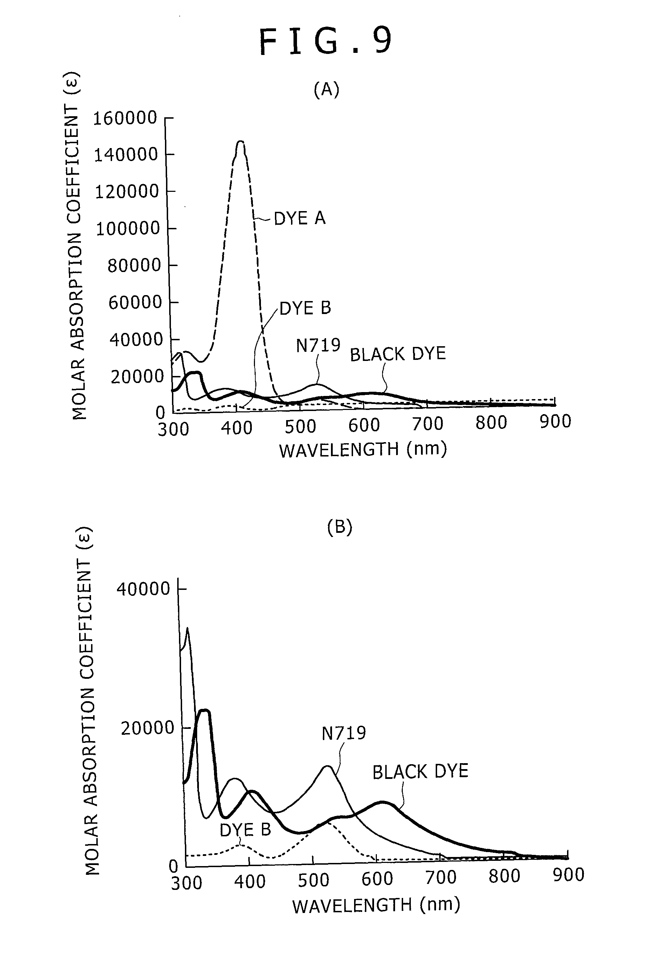

Fig. 9(A) shows absorption spectra of four kinds of typical dyes generally available at present and Fig. 9(B) is a graph showing, in an enlarged scale, absorption spectra of three kinds of dyes with small molar absorption coefficient. It can be seen from Figs. 9(A) and 9(B) that the black dye has an absorption wavelength region for a wide range with an end for a long wavelength at about at 860 nm but entirely has a small molar absorption coefficient and, particularly, a region of insufficient absorption coefficient is present on the side of a short wavelength. The N719 has a molar absorption coefficient equal with or larger than that of the black dye on the side of the short wavelength but the end on the side of the long wavelength of the absorption wavelength region is at about 730 nm, and a light of longer wavelength cannot be utilized effectively. Light absorption by 5-[[4-(4-(2,2-diphenylethenyl)phenyl]-1,2,3,3a,4,8b-hexahydrocyclopent[b]indol-7-yl]methylene]-2-(3-ethyl-4-oxo-2-thioxo-5-thiazolidinylidene)-4-oxy-3-Thiazolidineacetic acid (hereinafter referred to as "dye B") has a wavelength dependence substantially identical with that of the N719 and the molar absorption coefficient is smaller than that of the N719. While 2-Cyano-3-[4-[4-(2,2-diphenylethenyl)phenyl]-1,2,3,3a,4,8b-hexahydrocyclopent[b]indol-7-yl]-2-propenoic acid (hereinafter referred to as "dye A") has a large mol absorption coefficient, the range for the absorption wavelength is restricted to a narrow region.

At present as has been described above, a dye capable of thoroughly absorbing solar light for wavelength from 300 to 900 nm is not present. The highest performance in a case of using the dye sensitized photoelectric conversion device as a solar cell is attained in a case of using the N719 as the dye 107. For example, performance such as 0.755 V of open voltage and 8.23% of photoelectric conversion efficiency is obtained. When the result is compared with the performance of the open voltage of 0.6 V and the photoelectric conversion efficiency of 15% attained in the crystalline silicon solar cell, the photoelectric conversion efficiency remains at about one-half or more.

Considering that the open voltage is higher in the dye sensitized photoelectric conversion device than in the crystalline silicon solar cell, it is considered that the low photoelectric conversion efficiency of the dye sensitized solar cell is caused by the fact that the photo-current obtained is extremely smaller compared with the crystalline silicon solar cell and this is mainly attributable to that the light absorption rate of the dye 107 is insufficient. That is, it is considered that since a dye capable of efficiently absorbing all the lights of various wavelengths contained in solar light is not present, the light absorption rate is insufficient in a dye sensitized solar cell using one kind of dye.

Further, a method of manufacturing a $TiO_2$ paste in which fine particles of titanium oxide ($TiO_2$) are dispersed is known (for example, referred to Hironori Arakawa, "Recent Advances in Research and Development for Dye-Sensitized Solar Cells" (CMC) p.45-47 (2001)).

Disclosure of Invention

As described above, since a sufficient light absorption cannot be obtained with one kind of dye, it may be considered to use a plurality kinds of dyes with absorption wavelength characteristics different from each other in admixture as a sensitizing dye. However, when the plurality kinds of dyes are used being mixed on the semiconductor layer 103, the photoelectric conversion efficiency is actually lowered in most cases. This is because the ratio for obtaining a current from absorbed photons, that is, a quantum yield is remarkably lowered, for example, by electron transfer between dyes as already described.

In view of the above, the subject to be solved by the invention is to provide a dye sensitized photoelectric conversion device, for example, a dye sensitized solar cell capable of obtaining light absorption rate and photoelectric conversion efficiency higher than those in a case of using one kind of dye of high purity and a manufacturing method thereof, as well as a semiconductor electrode suitable to use in such a dye sensitized photoelectric conversion device and a manufacturing method thereof, as well as an electronic equipment using such a dye sensitized photoelectric device.

The present inventors have made an earnest study for solving the above subject and, as a result, have found that the light absorption rate and the photoelectric conversion efficiency can be improved remarkably by adsorbing two kinds of dyes in a specific combination as a sensitizing dye to a semiconductor electrode in a dye sensitized photoelectric conversion device, compared with a case of adsorbing one kind of dye to the semiconductor electrode. Then, as a result of conducting various experiments for making the reason apparent, they have found that when a plurality kinds of dyes in a specified combination are adsorbed to the semiconductor electrode, the adsorption amount of each of the dyes is substantially equal with the adsorption amount when the one kind of dye is adsorbed as will be described specifically later and, as a result of consideration based on the fact, have reached a conclusion that this is attributable to the adsorption of the dyes on the surface of the semiconductor electrode at the sites different from each other, and have achieved the present invention.

That is, for solving the subject described above, the first invention provides a dye sensitized photoelectric conversion device having an electrolyte layer between a semiconductor electrode to which a sensitizing dye is adsorbed and a counter electrode,
**characterized in that**
the dye includes two kinds of dyes and the two kinds of dyes are adsorbed onto a surface of the semiconductor electrode at the sites different from each other.

The second invention provides a method of manufacturing a dye sensitized photoelectric conversion device having an electrolyte layer between a semiconductor electrode to which a sensitizing dye is adsorbed and a counter electrode, **characterized in that**
the two kinds of dyes are adsorbed onto the surface of the semiconductor electrode at the sites different from each other by dipping the semiconductor electrode in a dye solution containing two kinds of dyes as the dye.

The third invention provides an electronic equipment using a dye sensitized photoelectric conversion device having an electrolyte layer between a semiconductor electrode to which a sensitizing dye is adsorbed and a counter electrode, **characterized in that**
the dye includes two kinds of dyes and the two kinds of dyes are adsorbed onto the surface of the semiconductor electrode at the sites different from each other.

The fourth invention provides a semiconductor electrode to which a sensitizing dye is adsorbed **characterized in that**
the dye includes two kinds of dyes and the two kinds of dyes are adsorbed onto the surface of the semiconductor electrode at the sites different from each other.

The fifth invention provides a method of manufacturing a semiconductor electrode to which a sensitizing dye is adsorbed **characterized in that**
the two kinds of dyes are adsorbed onto the surface of the semiconductor electrode at the sites different from each other by dipping the semiconductor electrode in a dye solution containing two kinds of dyes as the dye.

In the first to fifth inventions the sites different from each other on the surface of the semiconductor electrode mean, for example, crystal faces with indices being different from each other in which one of dyes is adsorbed specifically to an adsorption site on one crystal face, and the other dye is adsorbed specifically to the adsorption site on the other crystal face. Thus, when two kinds of dyes are adsorbed, the dyes can be adsorbed to respective crystal faces independently of each other and this can explain that the adsorption amount of each of the dyes, when the two kinds of dyes are adsorbed, is equal with the adsorption amount in a case of adsorbing one kind of dye.

In the first to fifth inventions, it is preferred that the two kinds of sensitizing dyes show a sensitizing effect and, in addition, a molecule of one dye has a carboxyl group on the adsorption end, and is bonded by the carboxyl group with the semiconductor electrode by dehydration reaction, and the molecule of the other dye is bonded to the adsorption end by weak electrostatic force with the carboxyl group and an auxiliary adsorption functional group (forming weak bond with a semiconductor electrode such as cyano group, amino group, thiol group and thion group). Specifically, the two kinds of dyes include a combination, for example, of the black dye and the dye A, or a combination of the black dye and the N719.

Optionally, one or a plurality kinds of other dyes may be adsorbed in addition to the two kinds of dyes described above to the semiconductor electrode. Other dyes include specifically, for example, xanthene type dyes such as rhodamine B, rose bengal, eosin, and erythrocine, cyanine type dyes such as merocyanine, quinocyanine, and criptocyanine, basic dyes such as phenosafranin, Cabri blue, thiosine, and methylene blue, porphyrin type compounds such as chlorophyll, zinc porphyrin, and magnesium porphyrin. Others include, for example, azo dye, phthalocyanine compound, coumarine compound, bipyridine complex compound, anthraquinone type dyes, polynuclear quinone type dyes, etc. Among them, a sensitizing dye of a complex having a ligand containing a pyridine ring or imidazolium ring and at least one metal selected from the group consisting of Ru, Os, Ir, Pt, Co, Fe, and Cu is preferred since the quantum yield is high.

While there is no particular restriction on the method of adsorbing the dye to the semiconductor electrode, the dyes described above may be dissolved in a solvent, for example, alcohols, nitriles, nitromethane, halogenated hydrocarbons, ethers, dimethyl sulfoxide, amides, N-methylpyrrolidone, 1,3-dimethyl imidazolidinone, 3-methyloxazolidinone, esters, carbonate esters, ketones, hydrocarbons, or water, to which the semiconductor electrode is dipped, or a solution containing the dye (dye solution) may be coated on the semiconductor substrate. Optionally, deoxycholic acid, etc. may be added with an aim of decreasing association between dye molecules to each other. Further, an UV-absorbent may be used in combination.

Optionally, after adsorbing the dye to the semiconductor electrode, the surface of the semiconductor electrode may be treated by using amines with an aim of promoting removal of excessively adsorbed dye. Examples of the amines include, for example, pyridine, 4-tert-butylpyridine, and polyvinyl pyridine. In a case where they are liquid, they may be used as they are or may be used being dissolved in an organic solvent.

The semiconductor electrode is disposed typically on a transparent conductive substrate. The transparent conductive substrate may be a transparent conductive film formed on a conductive or non-conductive transparent support substrate, or may be an entirely conductive transparent substrate. The material for the transparent support substrate is not particularly restricted and various base materials can be used so long as they are transparent. For the transparent support substrate, those excellent in blocking property for moisture or gas intruding from the outside of the photoelectric conversion device, solvent resistance, weather proofness, etc. and include, specifically, transparent inorganic substrates such as of quartz or glass, and transparent plastic substrates such as of polyethylene terephthalate, polyethylene naphthalate, polycarbonate, polystyrene, polyethylene, polypropylene, polyphenylene sulfide, polyvinylidene fluoride, tetraacetyl cellulose, brominated phenoxy, aramids, polyimides, polystyrenes, polyacrylates, polysulfones, and polyolefins. Among them, use of substrates having high transmittance in a visible-ray region is particularly preferred but this is not restrictive. As the transparent support substrate, use of transparent plastic substrates is preferred considering the fabricability, light weight, etc. Further, the thickness of the transparent support substrate is not particularly restricted and can be selected optionally depending on the light transmittance, the blocking property between the inside and the outside of the photoelectric conversion device.

The surface resistance (sheet resistance) of the transparent conductive substrate is preferably as low as possible. Specifically, the surface resistance of the transparent conductive substrate is, preferably, 500 $\Omega/cm^2$ or less and, more preferably, 100 $\Omega/cm^2$. In a case of forming a transparent conductive film on the transparent support substrate, known materials can be used therefor and include, specifically, indiumtin composite oxide (ITO), fluorine-doped $SnO_2$ (FTO), $SnO_2$, ZnO, indium-zinc composite oxide (IZO), etc., with no restriction to them. Further, two or more of them may be used in combination. Further, with an aim of lowering the surface resistance to improve the current collecting efficiency of the transparent conductive substrate, wirings including a conductive material such as a highly conductive metal may be disposed separately on the transparent conductive substrate. While there is no particular restriction on the conductive material used for the wiring, it is desirable that the corrosion resistance and oxidation resistance are high and leak current from the conductive material per se is low. However, even a conductive material of low corrosion resistance can also be used by additionally providing a protection layer including a metal oxide or the like. Further, with an aim of protecting the wiring against corrosion or the like, the wiring is preferably disposed between the transparent conductive substrate and the protective layer.

The semiconductor electrode includes, typically, fine semiconductor particles. As the material for the fine semiconductor particles, various kinds of compound semiconductors, compounds having a perovskite structure, etc. can be used in addition to elemental semiconductors typically represented by silicon. It is preferred that the semiconductors are n-type semiconductors in which conduction band electrons form carriers under light excitation to provide an anode current. Specific examples of the semiconductors are, for example, $TiO_2$, ZnO, $WO_3$, $Nb_2O_5$, $TiSrO_3$, and $SnO_2$ and, among them, anatase type $TiO_2$ is particularly preferred. The type of the semiconductors is not restricted to them and two or more of them may be mixed for use. Further, the fine semiconductor particles can optionally be in various forms such as granular shape, tubular shape, and bar-like shape.

There is no particular restriction on the grain size of the fine semiconductor particles but it is preferably from 1 to 200 nm, particularly preferably, from 5 to 100 nm as an average grain size of primary particles. Further, it is also possible to mix the fine semiconductor particles of the average grain size described above with fine semiconductor particles of an average grain size larger than the average grain size described above, thereby scattering incident light by the fine semiconductor particles of the larger average grain size to improve the quantum yield. In this case, the average grain size of the fine semiconductor particles mixed additionally is preferably from 20 to 500 nm.

The method of manufacturing the semiconductor electrode including the fine semiconductor particles has no particular restriction but a wet film forming method is preferred in a case of considering the physical property, conveniency, and manufacturing cost. A method of preparing a paste formed by uniformly dispersing a powder or sol of fine semiconductor particles in a solvent such as water, and coating the same on a transparent conductive substrate is preferred. The method of coating is not particularly restricted and can be conducted in accordance with the known method such as, for example, dip method, spray method, wire bar method, spin coat method, roller coat method, blade coat method, or gravure coat method. Alternatively, the wet printing method can be conducted by various methods, for example, relief printing, offset printing, gravure printing, intaglio printing, rubber printing, or screen printing. In a case of using crystalline titanium oxide as the material for the fine semiconductor particles, anatase form is preferred as the crystal form in view of the photocatalyst activity. The anatase type titanium oxide may be a commercial powder, sol, or slurry, or those of a predetermined grain size may be prepared by a known method such as hydrolysis of titanium oxide alkoxide. In a case of using the commercial powder, it is preferred to eliminate secondary aggregation of the particles, and particles are preferably pulverized by using a mortar or a ball mill upon preparation of the coating solution. In this case, for preventing re-aggregation of particles disintegrated from secondary aggregation, acetyl acetone, hydrochloric acid, nitric acid, surfactant, chelating agent, or the like may be added. Further, with an aim of improving the viscosity, various viscosity improvers such as a polymer, for example, polyethylene oxide or polyvinyl alcohol or a cellulose type viscosity improver can be added.

The fine semiconductor particle layer preferably has a large surface area such that it can adsorb a lot of dyes. For this purpose, the surface area in a state of coating the fine semiconductor particle layer on a support is preferably 10 times or more and, more preferably, 100 times or more to the projection area. There is no particular restriction on the upper limit but it is usually about 1000 times. The light capturing coefficient of the fine semiconductor particle layer is generally improved as the thickness of the layer increases since the amount of the carried dye per unit projection area is increased. However, since this increases the diffusion distance of injected electrons, loss due to the charge recombination is also increased. Accordingly, while a preferred thickness is present for the fine semiconductor particle layer, the thickness is generally from 0.1 to 100 $\mu$m, more preferably, from 1 to 50 $\mu$m and, particularly preferably, from 3 to 30 $\mu$m. The fine semiconductor particle layer is preferably baked into a porous state for electronically contacting particles to each other to improve the film strength or the adhesion with the substrate after coating on the substrate. While the range for the baking temperature is not particularly restricted, if the temperature is elevated excessively, the resistance of the substrate increases to sometimes cause melting, so that it is usually from 40 to 700°C and, more preferably, from 40 to 650°C. Further, while there is also no particular restriction on the baking time, it is usually about from 10 minutes to 10 hours. After the baking, a dipping treatment may be applied with, for example, an aqueous solution of titanium tetrachloride or a sol of an ultrafine particle titanium oxide with a diameter of 10 nm or less with an aim of increasing the surface area of the fine semiconductor particle layer or enhancing necking between fine semiconductor particles. In a case of using a plastic substrate for the support of the transparent conductive substrate, a paste containing the binder may be coated on the substrate and can be press bonded to the substrate by hot pressing.

For the counter electrode any material can be used so long as this is the conductive substance and even an insulative substance can also be used so long as a conductive layer is disposed on the side facing the semiconductor electrode. However, it is preferred to use an electrochemically stable material for the counter electrode material and, specifically, use of platinum, gold, carbon, a conductive polymer, etc. is desired. Further, with an aim of improving the effect of the redox catalyst, it is preferred that the side facing the semiconductor electrode is in a fine structure to increase the surface area. For example, it is desirably in a platinum black state in a case of platinum and in a porous state in a case of carbon. The state of platinum black can be formed by an anodizing method of platinum, a chloroplatinic acid treatment, or the like and carbon in the porous state can be formed by a method, for example, of sintering fine carbon particles or baking an organic polymer. Further, by wiring a metal of high redox catalytic effect such as platinum on a transparent conductive substrate, or applying a chloroplatinic acid treatment to the surface, it can be used as a transparent counter electrode.

As the electrolyte, a combination of iodine ($I_2$) and a metal iodide or an organic iodide or a combination of bromine ($Br_2$) and a metal bromide or an organic bromide, as well as a metal complex such as ferrocyanate salt/ferricyanate salt or ferrocene/ferricinium ion, sulfur compounds such as sodium polysulfide, alkylthiol/alkyldisulfide, viologen dyes, hydroquinone/quinine, etc. can be used. Li, Na, K, Mg, Ca, Cs, etc. are preferred as the cations of the metal compounds and quaternary ammonium compounds such as tetraalkyl ammoniums, pyridiniums, imidazoliums, etc. are preferred as the cation of the organic compounds but they are not restricted to them, or two or more of them may be used in admixture. Among them, the electrolyte including a combination of $I_2$ and LiI, NaI or a quaternary ammonium compound such as imidazolinium iodide is preferred. The concentration of the electrolyte salt to the solvent is, preferably, from 0.05 to 10 M and, more preferably, from 0.2 to 3 M. The concentration for $I_2$ or $Br_2$ is, preferably, from 0.0005 to 1 M and, more preferably, from 0.001 to 0.5 M. Further, with an aim of improving the open voltage and short circuit current, various additives such as 4-tert-butylpyridine or benzimidazoliums may also be added.

The solvent constituting the electrolyte composition includes, for example, water, alcohols, ethers, esters, carbonate esters, lactones, carboxylate esters, triphosphate ester, heterocyclic compounds, nitriles, ketones, amides, nitromethane, halogenated hydrocarbons, dimethylsulfoxide, sulfolane, N-methylpyrrolidone, 1,3-dimethylimidazolidinone, 3-methyloxazolidinone, and hydrocarbons, with no restriction to them. Further, two or more kinds of them may be used in admixture. Further, a room temperature ionic liquid such as of tetraalkyl type, pyridinium type, or imidazolium type quaternary ammonium salts can also be used as the solvent.

With an aim of decreasing the liquid leakage from the photoelectric conversion device and evaporation of the electrolyte, a gelling agent, polymer, crosslinking monomer, etc. may be dissolved into the electrolyte composition and can be used as the gel-like electrolyte. For the ratio for the gel matrix and the electrolyte composition, while the ionic conductivity is higher, the mechanical strength is lowered as the electrolyte composition is increased. On the contrary, while the mechanical strength is higher, the ionic conductivity is lowered when the electrolyte composition is excessively decreased. Then, the electrolyte composition is preferably from 50 to 99 wt% and, more preferably, from 80 to 97 wt% for the gel-like electrolyte. Further, an entirely solid type photoelectric conversion device can also be materialized by dissolving the electrolyte and the plasticizer in a polymer, evaporating and removing the plasticizer.

The method of manufacturing the photoelectric conversion device is not particularly restricted. However, in a case where, for example, the electrolyte composition is a liquid, or the electrolyte composition can be gelled in the inside of the photoelectric conversion device and is in a liquid state before introduction, a semiconductor electrode to which the sensitizing dye is adsorbed and the counter electrode are opposed to each other and a portion of the substrate not formed with the semiconductor electrode is sealed such that the electrodes are not in contact with each other. In this case, there is no particular restriction on the size of the gap between the semiconductor electrode and the counter electrode but it is usually from 1 to 100 μm and, more preferably, from 1 to 50 μm. When the distance between the electrodes is excessively long, photocurrent is decreased due to lowering of the conductivity. There is no particular restriction on the sealing method, but a material having light fastness, insulative property and moisture proofness is used preferably and epoxy resin, UV-ray curable resin, acryl resin, polyisobutylene resin, EVA (ethylene vinyl acetate), ionomer resin, ceramic, various fusible resins and the like can be used. In addition, various welding methods can be used. Further, while an injection port for injecting a solution of the electrolyte composition is necessary, the place for the injection port is not particularly restricted so long as it is not on the semiconductor electrode to which the dye is adsorbed or a portion of the counter electrode opposing thereto. An injection method is not particularly restricted but a method of injecting a liquid to the inside of the cell which is previously sealed and formed with an injection port for the solution is preferred. In this case, a method of dripping several drops of the solution to the injection port and injecting the solution by a capillary phenomenon is simple and convenient. Further, the solution injecting operation may be conducted optionally under a reduced pressure or under heating. After the solution is completely injected, the solution remained at the injection port is removed and the injection port is sealed. There is also no particular restriction on the sealing method, however, sealing may be carried out if necessary by bonding a glass plate or a plastic substrate with a sealant. Alternatively, in a case of a gel-like electrolyte using a polymer or the like or in a case of a wholly solid type electrolyte, a polymer solution containing an electrolyte composition and a plasticizer is evaporated and removed on the semiconductor electrode to which the dye is adsorbed by a casting method. After completely removing the plasticizer, sealing is conducted in the same manner as in the method described above. This sealing is preferably conducted using a vacuum sealer or the like in an inert gas atmosphere or under a reduced pressure. After sealing, for sufficiently impregnating the electrolyte into the semiconductor electrode, heating or pressing operation may be conducted optionally.

The dye sensitized photoelectric conversion device can be manufactured in various shapes depending on the application use and the shape is not particularly restricted.

The dye sensitized photoelectric conversion device is constituted, most typically, as a dye sensitized solar cell. However, the dye sensitized photoelectric conversion device may be other than the photosensitized solar cell, for example, a dye sensitized sensor.

Basically, the electronic equipment may be any equipment and includes both portable type and fixed type. Specific examples include, for example, mobile phones, mobile equipments, robots, personal computers, on-vehicle instruments and various domestic electric appliances. In this case, the dye sensitized photoelectric conversion device is, for example, a dye sensitized solar cell used as a power source for such electronic equipments.

The semiconductor electrode is not always restricted to those used for the dye sensitized photoelectric conversion device but may be used for other application use.

The sixth invention provides a photoelectric conversion device having an electrolyte layer between a semiconductor layer to which a sensitizing dye is adsorbed and a counter electrode, **characterized in that**
the dye includes a plurality kinds of dyes, and at least two kinds of the dyes out of the plurality kinds of dyes are adsorbed onto the surface of the semiconductor electrode at the sites different from each other.

The seventh invention provides a method of manufacturing a dye sensitized electronic conversion device having an electrolyte layer between a semiconductor electrode to which a sensitizing dye is adsorbed and a counter electrode **characterized in that**
at least two kinds of dyes in the plurality kinds of dyes are adsorbed onto the surface of the semiconductor electrode at portions different from each other by dipping the semiconductor electrode in a dye solution containing a plurality kinds of dyes as the dye.

The eighth invention provides an electronic equipment using a dye sensitized photoelectric conversion device having an electrolyte layer between a semiconductor electrode to which a sensitizing dye is adsorbed and a counter electrode **characterized in that**
the dye includes a plurality kinds of dyes, and at least two kinds of dyes in the plurality kinds of dyes are adsorbed onto the surface of the semiconductor electrode at the sites different from each other.

The ninth invention provides a semiconductor electrode to which a sensitizing dye is adsorbed **characterized in that**
the dye includes a plurality kinds of dyes and at least two kinds of dyes in the plurality kinds of dyes are adsorbed onto the surface of the semiconductor electrode at the sites different from each other.

The tenth invention provides a method of manufacturing a semiconductor electrode to which sensitizing dye is adsorbed **characterized in that**
at least two kinds of dyes in a plurality kinds of dyes are adsorbed onto the surface of the semiconductor electrode at portions different from each other by dipping the semiconductor electrode in a dye solution containing a plurality kinds of dyes as the dye.

In the sixth to tenth invention, those explained referring to the first to fifth inventions are established.

In the invention constituted as described above, since at least two kinds of dyes are adsorbed onto the surface of the semiconductor electrode at the sites different from each other, the adsorption amount of each of the dyes can be made equal with that in the case of adsorbing the same alone and the dyes can be adsorbed each by a sufficient amount.

Brief Description of Drawings

[Fig. 1] Fig. 1 is a cross sectional view for a main portion of a dye sensitized photoelectric conversion device according to one embodiment of the invention.

[Fig. 2] Fig. 2 is a schematic diagram showing schematically a state where two kinds of dyes are adsorbed to a fine semiconductor particle layer in a dye sensitized photoelectric conversion device according to one embodiment of the invention.

[Fig. 3] Fig. 3 is an energy diagram for explaining the operation of the dye sensitized photoelectric conversion device according to one embodiment of the invention.

[Figs. 4] Figs. 4 are schematic diagrams showing chemical structures and IPCE spectra of a black dye and a dye A.

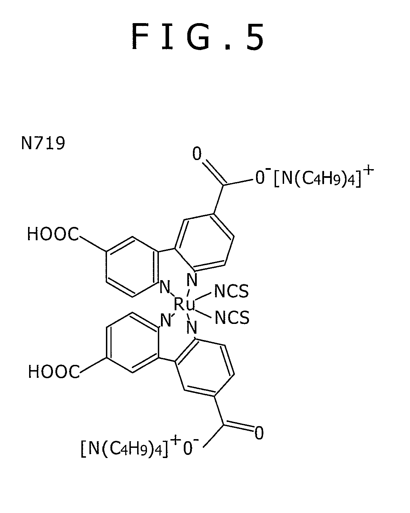

[Fig. 5] Fig. 5 is a schematic diagram showing the chemical structure of an N719.

[Fig. 6] Fig. 6 is a schematic diagram showing IPCE spectra of dye sensitized photoelectric conversion devices according to example and comparative examples of the invention.

[Fig. 7] Fig. 7 is a cross sectional view for a main portion of an existent dye sensitized photoelectric conversion device.

[Fig. 8] Fig. 8 is an energy view for explaining the operation of the existent dye sensitized photoelectric conversion device.

[Figs. 9] Figs. 9 are schematic diagrams showing light absorption characteristics of typical dyes.

Best Mode for Carrying Out the Invention

An embodiment of the invention will be described below with reference to the drawings. Further, throughout the drawings of the embodiment, identical or corresponding portions carry identical references.

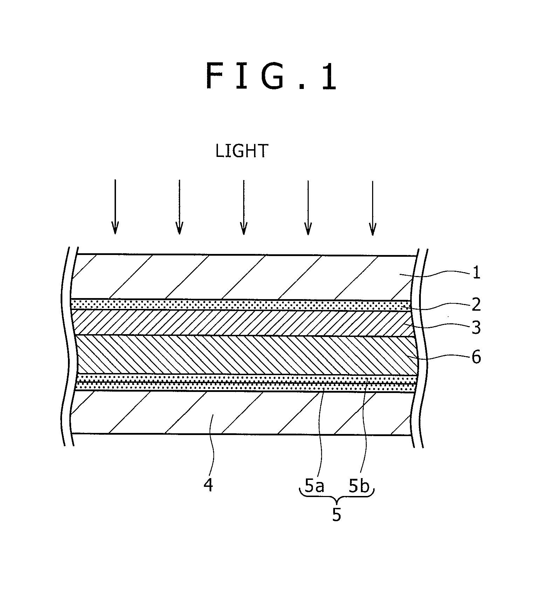

Fig. 1 shows a dye sensitized photoelectric conversion device according to the one embodiment.

As shown in Fig. 1, the dye sensitized photoelectric conversion device generally has a structure in which a portion having a transparent electrode 2 including, for example, FTO formed on a transparent substrate 1 made of glass or the like, on which a fine semiconductor particle layer 3 is formed with adsorption of a sensitizing dye, and a counter electrode 5 having an electrode 5a including, for example, FTO and a conduction layer 5b including a platinum layer or the like which are formed on a substrate 4 are opposed to each other, and an electrolyte layer 6 including an organic liquid electrolyte containing oxidation/reduction species (redox pair) such as $I^-/I_3^-$ is filled between them. The electrolyte layer 6 is sealed by a predetermined sealing member not shown in drawings. An external circuit is connected between the transparent electrode 2 and the counter electrode 5. As the fine semiconductor particle layer 3, for example, a porous layer formed by sintering fine semiconductor particles of $TiO_2$ or the like is used but this is not restrictive thereto. A sensitizing dye is adsorbed onto the surface of the fine semiconductor particles that constitute the fine semiconductor particle layer 3.

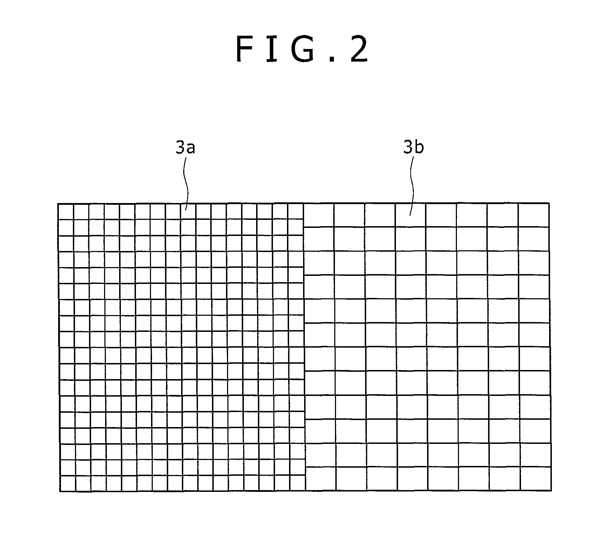

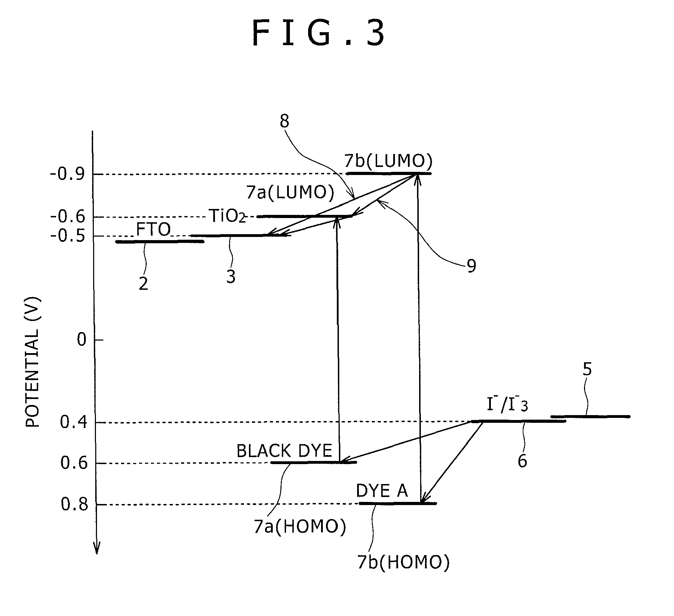

The characteristic feature of the dye sensitized photoelectric conversion device is that in the fine semiconductor particle layer 3, two kinds of dyes are absorbed as the sensitizing dye, onto the surface of the fine semiconductor particle layer 3, at the sites different from each other, for example, at the crystal faces with face indices different from each other on the fine semiconductor particles that constitute the fine semiconductor particle layer 3. This will be explained with reference to Fig. 2. Fig. 3 is an image view schematically showing two regions 3a, 3b with face indices different from each other present on the surface of the fine semiconductor particle layer 3. For example, the region 3a is a crystal face of (100) face and the region 3b is a crystal face of (110) face. Actually, a plurality of facets with the face indices different from each other is formed on the surface of the fine semiconductor particles that constitute the fine semiconductor particle layer 3 and they can be the regions 3a, 3b. In this case, one of the two kinds of dyes is adsorbed, for example, to the region 3a and the other is adsorbed, for example, to the region 3b. With such an arrangement, the adsorption amount for the two kinds of dyes can be made to an adsorption amount equal with that in the case of adsorbing each of them solely, and the adsorption amount for each of the two kinds of dyes can be increased sufficiently.

Next, a method of manufacturing the dye sensitized photoelectric conversion device will be described.

At first, the transparent substrate 1 is prepared, on which the transparent electrode 2 is formed. Next, a paste in which fine semiconductor particles are dispersed is coated on the transparent electrode 2 at a predetermined gap (thickness). Then, the semiconductor fine particles are sintered by heating the transparent substrate 1 to a predetermined temperature to form the fine semiconductor particle layer 3. Then, the transparent substrate 1 formed with the fine semiconductor fine particle layer 3 is dipped into a dye solution containing two kinds of dyes to adsorb the two kinds of the dyes to the fine semiconductor particle layer 3. In this case, since the two kinds of dyes are adsorbed specifically to the sites different from each other on the surface of the fine semiconductor particle layer 3 respectively, adsorption occur independently of each other and they do not deprive the adsorption sites with each other. Thus, the fine semiconductor particle layer 3 in which two kinds of dyes are adsorbed is formed.

On the other hand, a substrate 4 is prepared separately, on which the electrode 5a and the conductive layer 5b are formed to form the counter electrode 5. Then, the transparent substrate 1 and the substrate 4 are arranged such that the fine semiconductor particle layer 3 and the counter electrode 5 are opposed to each other at a predetermined distance, for example, of 1 to 100 $\mu$m, preferably, at a distance of 1 to 50 $\mu$m, and also a gap for sealing the electrolyte layer 6 is prepared by using a predetermined sealing member, then the electrolyte layer 6 is injected from a liquid injection port previously formed to the space. After that, the liquid injection port is closed. A dye sensitized photoelectric conversion device is thus manufactured.

The operation principle of the dye sensitized photoelectric conversion device will be described with reference to an energy diagram shown in Fig. 3. However, it is considered in Fig. 3 a case of using FTO as the material for the transparent electrode 2, a black dye and dye A as the two kinds of dyes 7a, 7b respectively, $TiO_2$ as the material for the fine semiconductor particle layer 3, and $I^-/I_3^-$ as redox species. In the dye sensitized photoelectric conversion device, when light is incident from the side of the transparent substrate 1, it operates as a cell using the counter electrode 5 as a positive electrode and a transparent electrode 2 as the negative electrode. The principle thereof will be described below.

That is, when the dyes 7a, 7b absorb photons transmitted through the transparent substrate 1 and the transparent electrode 2, electrons in the dyes 7a, 7b are excited from the ground state (HOMO) to the excite state (LUMO). In this case, since the two kinds of the dyes 7a, 7b (for example, black dye and dye A) are used, a light in a wider wavelength region can be absorbed at a higher light absorption rate compared with the existent dye sensitized photoelectric conversion device using only one kind of the dye. The thus excited electrons are drawn to the conduction band of the fine semiconductor particle layer 3 and reach the transparent electrode 2 passing through the fine semiconductor particle layer 3. In this case, since the two kinds of the dyes 7a, 7b, for example, the black dye and the dye A include dyes with the minimum excitation energy being different sufficiently from each other, these dyes 7a, 7b do not lower the quantum yield between each other and the photoelectric conversion function due to these dyes 7a, 7b are developed to greatly improve the generation amount of current.

On the other hand, the dyes 7a, 7b deprived of the electrons receive electrons from a reducing agent, that is, $I^-$ in the electrolyte layer 6 in accordance with the following reaction:

$$2I^- \rightarrow I_2 + 2e^-$$

$$I_2 + I^- \rightarrow I_3^-$$

thereby forming an oxidant, that is, $I_3^-$ (bonded body of $I_2$ and $I^-$) in the electrolyte layer 6. The thus formed oxidant reaches the counter electrode 5 by way of diffusion, and receives electrons from the counter electrode 5 by the reaction reverse to the reaction described above:

$$I_3^- \rightarrow I_2 + I^-$$

$$I_2 + 2e^- \rightarrow 2I^-$$

and are reduced to the reducing agent in the initial state.

Electrons derived from the transparent electrode 2 to an external circuit conduct an electric work in the external circuit and then return to the counter electrode 5. In this way, light energy is converted into electric energy not leaving any change in the dyes 7a, 7b or the electrolyte layer 6.

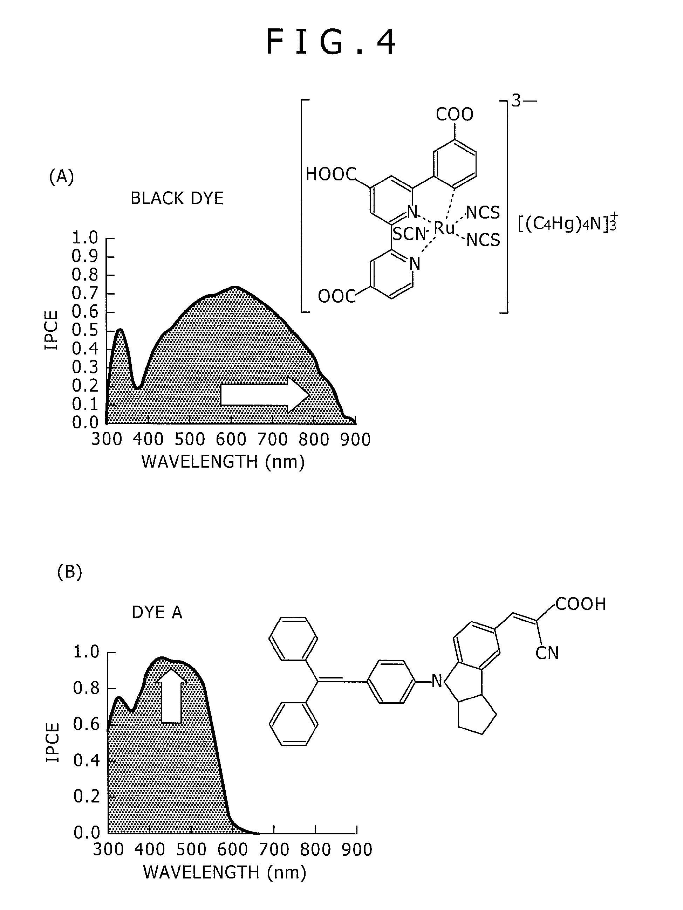

Figs. 4 are explanatory views showing the structural formula and IPCE (Incident Photon-to-current Conversion Efficiency) spectra for each of the dyes in the combination of the black dye (Fig. 4(A)) and the dye A (Fig. 4(B)) providing the highest performance improving effect. It can be seen from Figs. 4, and Figs. 9 shown previously, that there is a relation in which the light absorption in the short wavelength region where the absorption of the black dye as the basic dye is insufficient is assisted by the dye A as an auxiliary dye. In addition, the absorption peak wavelength is present in the wavelength region of 400 nm or more and the end on the side of the long wavelength in the absorption wavelength region is present at about 860 nm for the black dye, whereas the absorption peak wavelength is present in the wavelength region of 400 nm or less and the end on the side of the long wavelength in the absorption wavelength region is present at about 480 nm for the dye A. This represents that the band gap energies of both of the dyes are greatly different from each other. In a case where the black dye and the dye A are present being mixed on the fine semiconductor particle layer 3, the photoelectric conversion efficiency is not lowered different from the example known so far. This is considered because both of the dyes are adsorbed each by a sufficient amount at the sites different from each other on the surface of the fine semiconductor particle layer 3 and, in addition, the band gap energies of both of the dyes are different greatly from each other, electron transfer less occur between the dyes.

The energy diagram in Fig. 3 shows a mechanism that the photoelectric conversion efficiency of the dye A is improved in a system where the dyes 7a, 7b include the black dye and the dye A. As has been described above, when respective dyes absorb photons respectively, electrons in the dye are excited from the ground state (HOMO) to the excited state (LUMO). In this system, there are present two types of paths where electrons in the excited state of the dye A are drawn out to the conduction band of the fine semiconductor particle layer 3. That is, there are a direct path 8 where they are drawn directly from the excited state of the dye A to the conduction band of fine semiconductor particle layer 3 and an indirect path 9 where the excited electrons of the dye A are at first drawn to the excited state of the black dye at a low energy level and then drawn out from the excited state of the black dye to the conduction band of the fine semiconductor particle layer 3. By the contribution of the indirect path 9, the photoelectric conversion efficiency of the dye A is improved in a system where the black dye is present together.

An example of a dye sensitized photoelectric conversion device will be described.

(Example)

Fine $TiO_2$ particles were used as the fine semiconductor particles. A paste in which fine $TiO_2$ particles were dispersed was prepared with reference to Hironori Arakawa, "Recent Advances in Research and Development for Dye-Sensitized Solar Cells" (CMC) p.45-47 (2001) as described below. 125 mL of titanium isopropoxide was dropped slowly into 750 mL of an aqueous solution of 0.1M nitric acid under stirring at a room temperature. After the completion of the dropping, the solution was transferred to a thermostable bath at 80°C, and stirred for 8 hours to obtain a clouded semi-transparent sol solution. After that, the sol solution was allowed to cool to a room temperature, and filtered through a glass filter, and it was measured up to 700 mL. The obtained sol solution was transferred to an autoclave and, after hydrothermic treatment at 220°C for 12 hours, applied with a dispersing treatment by conducting a supersonic treatment for 1 hour. Next, the solution was concentrated by an evaporator at 40°C to prepare such that the content of $TiO_2$ was 20 wt%. To the concentrated sol solution, 20 wt% of polyethylene glycol (molecular weight 500,000) based on $TiO_2$ in the paste and 30 wt% of anatase type $TiO_2$ with 200 nm grain size based on $TiO_2$ in the paste were added, and they were mixed uniformly in a stirring defoamer to obtain a $TiO_2$ paste of increased viscosity.

Next, after coating the $TiO_2$ paste obtained as described above to an FTO substrate by a blade coating method to 5 mm × 5 mm size at 200 $\mu$m gap, it was kept at 500°C for 30 minutes and $TiO_2$ was sintered on the FTO substrate. Then, an aqueous 0.1M solution of $TiCl_4$ was dropped to the sintered $TiO_2$ film and, after keeping at a room temperature for 15 hours, it was cleaned and then sintered again at 500°C for 30 minutes.

Next, impurities of the thus prepared $TiO_2$ sintered product were removed and UV-ray exposure was applied for 30 minutes by an UV-ray irradiation apparatus with an aim of increasing the activity.

Next, sufficiently purified 25.5 mg of a black dye and 3.2 mg of a dye A were dissolved in 50 mL of a mixed solvent of acetonitrile : tert-butanol = 1:1. Then, the semiconductor electrode was dipped in the dye solution at a room temperature for 72 hours to adsorb the dyes. The semiconductor electrode was cleaned with a mixed solvent of acetonitrile : tert-butanol = 1:1, and then with acetonitrile in this order and dried in a dark place.

Cr at 50 nm thickness and then Pt at 100 nm thickness were sputtered successively to an FTO substrate previously formed with a liquid injection port of 0.5 mm, and then a solution of chloroplatinic acid in isopropyl alcohol (IPA) was spray coated thereover, and heated at 385°C for 15 minutes, which was used as the counter electrode.

Next, the $TiO_2$ surface of the dye adsorbed fine $TiO_2$ particle layer formed as described above, that is, the dye sensitized semiconductor electrode and the Pt surface of the counter electrode were opposed to each other and the outer peripheries of them were sealed with an ionomer resin film of 30 $\mu$m thickness and an acrylic UV-ray curable resin.

On the other hand, 0.030 g of sodium iodide (NaI), 1.0 g of 1-prolyl-2,3-dimethylimidazolium iodide, 0.10 g of iodine ($I_2$), and 0.054 g of 4-tert-butyl pyridine were dissolved in 2 g of methoxy acetonitrile to prepare an electrolyte composition.

The solution mixture was injected from the liquid injection port of the previously prepared device by using a liquid feed pump and bubbles in the inside of the device were purged by depressurization. Then, the liquid injection port was sealed with an ionomer resin film, acrylic resin, and a glass substrate to obtain a dye sensitized photoelectronic conversion device.

For estimating the adsorption amount of the dye, the dye adsorbed semiconductor electrode was at first dipped into an hydrous acetic acid and stood still at 30°C for 1 hour to leach only the dye A. Then, it was dipped into an aqueous solution of 0.1N sodium hydroxide to leach the black dye immediately. The dye adsorption amount was calculated based on the molar absorption coefficient for each of the solutions.

(Comparative Example A)

A dye sensitized photoelectric conversion device was manufactured in the same manner as in the example except for adsorbing only the dye A to the semiconductor electrode.

That is, 3.2 mg of the dye A was dissolved in 50 mL of a mixed solvent of acetonitrile : tert-butanol = 1:1. Then, the semiconductor electrode described above was dipped into the dye solution for 12 hours under a room temperature to adsorb the dye. The semiconductor electrode was cleaned with a mixed solvent of acetonitrile : tert-butanol = 1:1, and with acetonitrile in this order and dried in a dark place.

For estimating the adsorption amount of the dye, the dye adsorbed semiconductor electrode was dipped into anhydrous acetic acid and stood still at 30°C for 1 hour to leach the dye A. The adsorption amount of the dye was calculated based on the molar absorption coefficient of the dye A in anhydrous acetic acid.

(Comparative Example B)

A dye sensitized photoelectric conversion device was manufactured in the same manner as in the example except for adsorbing only the black dye to the semiconductor electrode.

That is, 13.6 mg of a sufficiently purified black dye was dissolved in 50 mL of a mixed solvent of acetonitrile : tert-butanol = 1:1. Then, the semiconductor electrode described above was dipped into the dye solution for 72 hours under a room temperature to adsorb the dye. The semiconductor electrode was cleaned with a mixed solvent of acetonitrile : tert-butanol = 1:1, and with acetonitrile in this order and dried in a dark place.

For estimating the adsorption amount of the dye, the dye adsorbed semiconductor electrode was dipped into an aqueous solution of 0.1N sodium hydroxide, to leach the black dye immediately. The adsorption amount of the dye was calculated based on the molar absorption coefficient of the black dye in an aqueous solution of 0.1N sodium hydroxide.

(Comparative Example C)

A dye sensitized photoelectric conversion device was manufactured in the same manner as in the example except for adsorbing only the N719 to the semiconductor electrode.

That is, 17.8 mg of a sufficiently purified N719 was dissolved in 50 mL of a mixed solvent of acetonitrile : tert-butanol = 1:1. Then, the semiconductor electrode described above was dipped into the dye solution for 72 hours under a room temperature to adsorb the dye. The semiconductor electrode was cleaned with a mixed solvent of acetonitrile : tert-butanol = 1:1, and with acetonitrile in this order, and dried in a dark place.

For estimating the adsorption amount of the dye, the dye adsorbed semiconductor electrode was dipped into an aqueous solution of 0.1N sodium hydroxide, to leach the N719 immediately. The adsorption amount of the dye was calculated based on the molar absorption coefficient of the N719 in an aqueous solution of 0.1N sodium hydroxide.

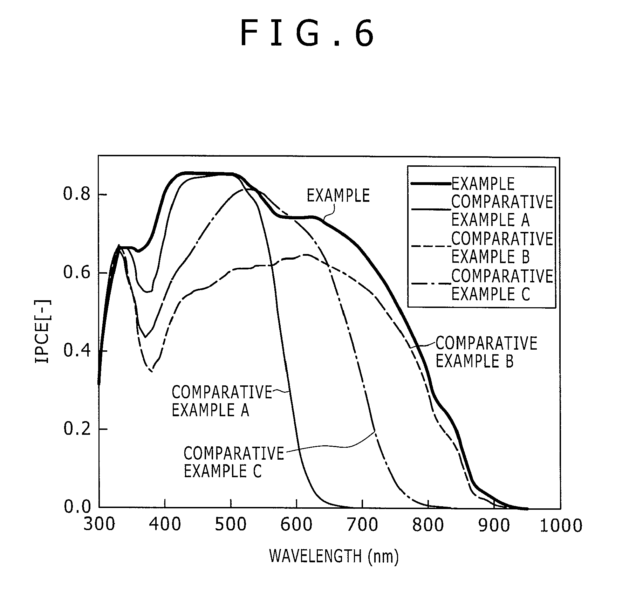

In the dye sensitized photo electric conversion devices of the example and the Comparative Examples A to C manufactured as described above, open voltage ($V_{OC}$), short circuit current ($J_{SC}$), fill factor (ff), and photoelectric conversion efficiency of a curve, I(current) - V (voltage), under the irradiation of pseudo sunlight (AM 1.5, 100 mW/cm$^2$) were measured. The result of measurement is shown in Table 1. The result of measurement for dye absorption amount is shown in Table 2. Further, the result of measurement for IPCE is shown in Fig. 6.

[Table 1]

|  | Voc [mV] | Jsc [mA/cm$^2$] | Fill factor (%) | Photoelectric conversion efficiency (%) |
|---|---|---|---|---|
| Example | 680 | 20.36 | 65.4 | 9.06 |
| Comparative Example A | 611 | 11.06 | 68.9 | 4.66 |
| Comparative Example B | 687 | 12.63 | 70.4 | 6.11 |
| Comparative Example C | 731 | 14.77 | 71.2 | 7.68 |

[Table 2]

| Name of dye | Content | Mol/cm$^2$ |
|---|---|---|
| Dye A | | $2.7 \times 10^{-7}$ |
| Black dye | | $5.1 \times 10^{-7}$ |
| N719 | | $8.2 \times 10^{-7}$ |
| Example | Dye A | $2.2 \times 10^{-7}$ |
| | Black dye | $4.6 \times 10^{-8}$ |

It can be seen from Table 1 that the photoelectric conversion efficiency is improved drastically in the dye sensitized photoelectric conversion device of the example using the two kinds of dyes including the black dye and the dye A, when compared with the dye sensitized photoelectric conversion devices of Comparative Examples A to C using only one kind of dye.

It can be seen from Table 2 that the adsorption amount for each of the two kinds of dyes, that is, the black dye and the dye A in the example is substantially identical with the adsorption amount when each of the black dye and the dye A is adsorbed solely. Based on the result of measurement for the dye adsorption amount, it can be considered that the black dye and the dye A are adsorbed respectively to different sites on the surface of the semiconductor electrode.

It can be seen from the result of measurement for IPCE in Fig. 6 that larger IPCE is obtained in a wider range of wavelength region in the example compared with that in Comparative Examples A to C.

As described above according to the one embodiment, since the sensitizing dyes 7a, 7b are adsorbed onto the surface of the fine semiconductor particle layer 3 at the sites different from each other, the adsorption amount for each of the dyes 7a, 7b can be adsorbed by the amount equal with that in a case of adsorbing the dyes 7a, 7b solely, thereby capable of attaining a high performance dye sensitized photoelectric conversion device having higher light absorption rate and photoelectric conversion efficiency compared with those of the existent dye sensitized photoelectric conversion device using only one kind of dye.

While the present invention has been described specifically for the one embodiment and the example of the invention, the invention is not restricted to the embodiment and the example described above, and various modifications are possible based on the technical idea of the invention.

For example, numerical values, structures, shapes, materials, starting materials, processes and the like referred to in the embodiment and the example described above are merely examples, and numerical values, structures, shapes, materials, starting materials, processes, and the like different from them may also be used optionally.

According to the invention, since the two kinds of dyes which are different in the band gap energy and the absorption wavelength region from each other can be absorbed each by a sufficient amount to the semiconductor electrode, a dye sensitized photosensitive conversion device of high light absorption rate and photoelectric conversion efficiency can be attained. Then, a high performance electronic equipment can be attained by using the dye sensitized photoelectric conversion device of such high performance.

Claims

1.  A dye sensitized photoelectric conversion device having an electrolyte layer between a semiconductor electrode to which a sensitizing dye is adsorbed and a counter electrode, **characterized in that**
the dye comprises two kinds of dyes and the two kinds of dyes are adsorbed onto a surface of the semiconductor electrode at sites different from each other.

2.  The dye sensitized photoelectric conversion device according to claim 1 **characterized in that** the semiconductor electrode comprises fine semiconductor particles.

3.  The dye sensitized photoelectric conversion device according to claim 2 **characterized in that** the fine semiconductor particles comprise titanium oxide.

4.  The dye sensitized photoelectric conversion device according to claim 3 **characterized in that** the two kinds of dyes comprise tris(isothiocyanate)-ruthenium(II)-2,2':6',2"-terpyridine-4,4',4"-tricarboxylic acid and 2-cyano-3-[4-[4-(2,2-diphenylethenyl)phenyl]-1,2,3,3a,4,8b-hexahydrocyclopent[b]indol-7-yl]-2-propenoic acid.

**5.** The dye sensitized photoelectric conversion device according to claim 3 **characterized in that** the two kinds of dyes comprise tris(isothiocyanate)-ruthenium(II)-2,2':6',2"-terpyridine-4,4',4"-tricarboxylic acid and a bis(2,2'-dipyridyl-4,4'-dicarboxylic acid)-ruthenium(II)2 tetrabutyl ammonium complex.

**6.** A method of manufacturing a dye sensitized photoelectric conversion device having an electrolyte layer between a semiconductor electrode to which a sensitizing dye is adsorbed and a counter electrode, **characterized in that** two kinds of dyes are adsorbed onto the surface of the semiconductor electrode at the sites different from each other by dipping the semiconductor electrode in a dye solution containing two kinds of dyes as the dye.

**7.** The method of manufacturing a dye sensitized photoelectric conversion device according to claim 6 **characterized in that** the semiconductor electrode comprises fine semiconductor particles.

**8.** The method of manufacturing a dye sensitized photoelectric conversion device according to claim 7 **characterized in that** the fine semiconductor particles comprise titanium oxide.

**9.** The method of manufacturing a dye sensitized photoelectric conversion device according to claim 8 **characterized in that** the two kinds of dyes comprise tris(isothiocyanate)-ruthenium(II)-2,2':6',2"-terpyridine-4,4',4"-tricarboxylic acid and 2-cyano-3-[4-[4-(2,2-diphenylethenyl)phenyl]-1,2,3,3a,4,8b-hexahydrocyclopent[b]indol-7-yl]-2-propenoic acid.

**10.** The method of manufacturing a dye sensitized photoelectric conversion device according to claim 8 **characterized in that** the two kinds of dyes comprise tris(isothiocyanate)-ruthenium(II)-2,2':6',2"-terpyridine-4,4',4"-tricarboxylic acid and a bis(2,2'-dipyridyl-4,4'-dicarboxylic acid)-ruthenium(II)2 tetrabutyl ammonium complex.

**11.** An electronic equipment using a dye sensitized photoelectric conversion device having an electrolyte layer between a semiconductor electrode to which a sensitizing dye is adsorbed and a counter electrode, **characterized in that** the dye comprises two kinds of dyes and the two kinds of dyes are adsorbed onto the surface of the semiconductor electrode at the sites different from each other.

**12.** A semiconductor electrode to which a sensitizing dye is adsorbed **characterized in that** the dye comprises two kinds of dyes and the two kinds of dyes are adsorbed onto the surface of the semiconductor electrode at the sites different from each other.

**13.** A method of manufacturing a semiconductor electrode to which a sensitizing dye is adsorbed **characterized in that** the two kinds of dyes are adsorbed onto the surface of the semiconductor electrode at the sites different from each other by dipping the semiconductor electrode in a dye solution containing two kinds of dyes as the dye.

**14.** A photoelectric conversion device having an electrolyte layer between a semiconductor electrode to which a sensitizing dye is adsorbed and a counter electrode,
**characterized in that**
the dye comprises a plurality kinds of dyes, and at least two kinds of dyes in the plurality kinds of dyes are adsorbed onto the surface of the semiconductor electrode at the sites different from each other.

**15.** A method of manufacturing a dye sensitized electronic conversion device having an electrolyte layer between a semiconductor electrode to which a sensitizing dye is adsorbed and a counter electrode **characterized in that** at least two kinds of dyes in the plurality kinds of dyes are adsorbed onto the surface of the semiconductor electrode at sites different from each other by dipping the semiconductor electrode in a dye solution containing a plurality kinds of dyes as the dye.

**16.** An electronic equipment using a dye sensitized photoelectric conversion device having an electrolyte layer between a semiconductor electrode to which a sensitizing dye is adsorbed and a counter electrode **characterized in that** the dye comprises a plurality kinds of dyes, and at least two kinds of dyes in the plurality kinds of dyes are adsorbed onto the surface of the semiconductor electrode at the sites different from each other.

**17.** A semiconductor electrode to which a sensitizing dye is adsorbed **characterized in that** the dye comprises a plurality kinds of dyes, and at least two kinds of dyes in the plurality kinds of dyes are adsorbed onto the surface of the semiconductor electrode at the sites different from each other.

18. A method of manufacturing a semiconductor electrode to which a sensitizing dye is adsorbed **characterized in that** at least two kinds of dyes in the plurality kinds of dyes are adsorbed onto the surface of the semiconductor electrode at the sites different from each other by dipping the semiconductor electrode in a dye solution containing a plurality kinds of dyes as the dye.

# FIG.1

LIGHT

# F I G . 2

3a                        3b

EP 2 175 516 A1

# FIG.3

18

# F I G . 4

(A)

BLACK DYE

(B)

DYE A

# F I G . 5

N719

# FIG.6

# FIG.7

LIGHT

- 101
- 102
- 103
- 106

104        105a    105b
                105

# FIG.8

# FIG.9

(A)

(B)

**INTERNATIONAL SEARCH REPORT**

| International application No. |
| --- |
| PCT/JP2008/058718 |

A.   CLASSIFICATION OF SUBJECT MATTER
*H01M14/00*(2006.01)i, *H01L31/04*(2006.01)i

According to International Patent Classification (IPC) or to both national classification and IPC

B.   FIELDS SEARCHED

Minimum documentation searched (classification system followed by classification symbols)
H01M14/00, H01L31/04

Documentation searched other than minimum documentation to the extent that such documents are included in the fields searched
Jitsuyo Shinan Koho          1922-1996   Jitsuyo Shinan Toroku Koho    1996-2008
Kokai Jitsuyo Shinan Koho    1971-2008   Toroku Jitsuyo Shinan Koho    1994-2008

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
| --- | --- | --- |
| X<br>A | JP 2005-346934 A  (Casio Computer Co., Ltd.),<br>15 December, 2005 (15.12.05),<br>Claims; Figs. 6, 8, 17<br>& US 2005/0254226 A1 | 1-3<br>4 |
| X<br>A | JP 2006-179488 A  (Konarka Technologies, Inc.),<br>06 July, 2006 (06.07.06),<br>Claims; Par. Nos. [0029], [0064] to [0066];<br>Fig. 2<br>& US 2006/0130895 A1 | 1-3<br>4 |
| X | JP 2003-249279 A  (Sharp Corp.),<br>05 September, 2003 (05.09.03),<br>Claims; Par. Nos. [0041] to [0046]<br>(Family: none) | 1-3 |

☒ Further documents are listed in the continuation of Box C.          ☐ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>  18 July, 2008 (18.07.08) | Date of mailing of the international search report<br>  29 July, 2008 (29.07.08) |
| --- | --- |
| Name and mailing address of the ISA/<br>  Japanese Patent Office | Authorized officer |
| Facsimile No. | Telephone No. |

Form PCT/ISA/210 (second sheet) (April 2007)

25

**INTERNATIONAL SEARCH REPORT**

| International application No. |
|---|
| PCT/JP2008/058718 |

C (Continuation). DOCUMENTS CONSIDERED TO BE RELEVANT

| Category* | Citation of document, with indication, where appropriate, of the relevant passages | Relevant to claim No. |
|---|---|---|
| X | JP 2004-6235 A (Nagoya Industrial Science Research Institute), 08 January, 2004 (08.01.04), Claims; Par. No. [0029] & US 2006/0162765 A1 | 1 |

Form PCT/ISA/210 (continuation of second sheet) (April 2007)

**INTERNATIONAL SEARCH REPORT**

| International application No. |
| --- |
| PCT/JP2008/058718 |

**Box No. II          Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III          Observations where unity of invention is lacking (Continuation of item 3 of first sheet)**

This International Searching Authority found multiple inventions in this international application, as follows:
   As described in the extra sheet, in order that a group of inventions described in the claims comply with the requirement of unity of invention, a special technical feature for linking the group of inventions so as to form a single general inventive concept should exist.   It is recognized that eight inventions classified into "claims 1 to 4", "claim 5", "claims 6 to 10, 13, 15, and 18", "claim 11", "claim 12", "claim 14", "claim 16", and "claim 17" are described in the claims of this international application.

   (continued to extra sheet)

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.:
   Claims 1 to 4

**Remark on Protest**
the

☐ The additional search fees were accompanied by the applicant's protest and, where applicable, payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

**INTERNATIONAL SEARCH REPORT**

International application No.

PCT/JP2008/058718

Continuation of Box No.III of continuation of first sheet(2)

In order that a group of inventions described in the claims comply with the requirement of unity of invention, a special technical feature for linking the group of inventions so as to form a single general inventive concept should exist. The group of inventions described in claims 1 to 18 are linked to each other only in the matter that a plurality of coloring matters are adsorbed on respective different sites of the surface of a semiconductor electrode.

This matter, however, is described in the prior art document, for example, in patent document 1: JP 2005-346934 A (CASIO COMPUTER Co., LTD.) 2005. 12. 15, patent document 2: JP 2006-179488 A (Konarka Technologies, Inc.) 2006. 07. 06, patent document 3: JP 2003-249279 A (SHARP CORPORATION) 2003. 09. 05, patent document 4: JP 2004-6235 A (Chubu Technology Licensing Office) 2004. 01. 08, and patent document 5: JP 2000-268891 A (TOSHIBA CORPORATION) 2000. 09. 29, and thus cannot be a special technical feature.

Accordingly, there is no special technical feature among the group of inventions described in claims 1 to 18 so linked as to form a single general inventive concept. Thus, it is apparent that the group of inventions described in claims 1 to 18 do not comply with the requirement of unity of invention.

Next, the number of invention groups, which are described in the claims of the international application and are so linked as to form a general inventive concept, that is, the number of inventions, will be reviewed.

In the claims of this international application, claim 1 is defined, and claim 2 is defined by making reference to claim 1. Claim 3 is defined by making reference to claim 2. Claims 4 and 5 are defined by making reference to claim 3. Claim 6 is defined, and claim 7 is defined by making reference to claim 6. Claim 8 is defined by making reference to claim 7. Claims 9 and 10 are defined by making reference to claim 8. Further, claim 11, claim 12, claim 13, claim 14, claim 15, claim 16, claim 17, and claim 18 are respectively defined.

Claims 4 and 5 are linked to each other only in the matter described in claim 3. This matter, however, is described in each of the above documents 1 to 3 and thus cannot be a special technical feature. Accordingly, the invention of "claims 1 to 4" and the invention of "claim 5" are different from each other.

When whether or not there is other special technical feature which links a plurality of inventions is reviewed, it is recognized that claims 6 to 10, claim 13, claim 15, and claim 18 are linked by a special technical feature that a plurality of types of coloring matters are adsorbed on respective different sites of the surface of the semiconductor electrode by immersing a semiconductor electrode in a solution containing a plurality of types of coloring matters. On the other hand, the semiconductor electrode comprising a plurality of types of coloring matters adsorbed onto respective different sites of the surface of the semiconductor electrode, the coloring matter-sensitized photoelectric conversion element comprising the semiconductor electrode, and the electronic equipment comprising the coloring matter-sensitized

(continue to next page)

Form PCT/ISA/210 (extra sheet) (April 2007)

**INTERNATIONAL SEARCH REPORT**

International application No.

PCT/JP2008/058718

photoelectric conversion element are described in the above documents 1 to 5 and thus cannot be a special technical feature.  Further, there is no other special technical feature which links a plurality of inventions.

In summary, eight inventions classified into "claims 1 to 4", "claim 5", "claims 6 to 10, 13, 15, and 18", "claim 11", "claim 12", "claim 14", "claim 16", and "claim 17" are described in the claims of this international application.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2664194 A

### Non-patent literature cited in the description

- **B. O'Regan ; M. Graetzel.** *Nature,* 1991, vol. 353, 737-749
- **K. Hara ; K. Miyamoto ; Y. Abe ; M. Yanagida.** *Journal of Physical Chemistry B,* 2005, vol. 109 (50), 23776-23778
- **Masatoshi Yanagida et al.** Electron transport process in dye sensitized titanium oxide nanocrystal electrode to which a ruthenium dipyridine complex and a ruthenium biquinoline complex are co-adsorbed. *Photochemical Discussion Meeting,* 2005, vol. 2, 132
- **Hironori Arakawa.** *Recent Advances in Research and Development for Dye-Sensitized Solar Cells,* 2001, 45-47